# EUROPÄISCHE PATENTSCHRIFT

(11) **EP 3 128 555 B1**
(45) Veröffentlichungstag und Bekanntmachung des Hinweises auf die Patenterteilung: **18.08.2021**
(21) Anmeldenummer: 16187828.5
(22) Anmeldetag: 25.06.2009
(51) Int. Cl.: H01L 27/15, H01L 33/38

(54) **LEUCHTDIODENCHIP MIT INTEGRIERTEM SCHUTZ GEGEN ELEKTROSTATISCHE ENTLADUNGEN UND ENTSPRECHENDES HERSTELLUNGSVERFAHREN**
LIGHT-EMITTING SEMI-CONDUCTOR CHIP WITH INTEGRATED ESD PROTECTION AND A METHOD FOR PRODUCING A LIGHT-EMITTING SEMICONDUCTOR CHIP
PUCE SEMI-CONDUCTRICE ÉMETTANT DE LUMIÈRE AVEC PROTECTION INTEGRÉE CONTRE DÉCHARGES ÉLECTROSTATIQUES ET PROCÉDÉ DE FABRICATION CORRESPONDANT

(30) Priorität: 24.07.2008 DE 102008034560
(43) Veröffentlichungstag der Anmeldung: 08.02.2017
(62) Teilanmeldung aus: 09775907.0
(73) Patentinhaber: OSRAM Opto Semiconductors GmbH, 93055 Regensburg (DE)
(72) Erfinder: Engl, Karl, 93080 Pentling (DE); Hahn, Berthold, 93155 Hemau (DE); Streubel, Klaus, 93164 Laaber (DE); Klein, Markus, 10250 Penang (MY)
(74) Vertreter: Epping - Hermann - Fischer

(56) Entgegenhaltungen:
- DE-A1-102005 043 649
- US-A1- 2006 060 880
- US-A1- 2006 281 203

## Beschreibung

Die vorliegende Anmeldung betrifft einen strahlungsemittierenden Halbleiterchip sowie ein Verfahren zur Herstellung eines strahlungsemittierenden Halbleiterchips.

Elektrostatische Entladung (Electrostatic Discharge) kann bei strahlungsemittierenden Halbleiterchips, beispielsweise bei Leuchtdioden, zur Schädigung bis hin zur Zerstörung führen. Eine solche Schädigung kann durch eine zum Halbleiterchip parallel geschaltete zusätzliche Diode vermieden werden, wobei die Durchlassrichtung der Diode und die Durchlassrichtung des strahlungsemittierenden Halbleiterchips antiparallel zueinander gerichtet sind. Durch diese zusätzliche Diode werden sowohl der Platzbedarf als auch die Herstellungskosten erhöht. Weiterhin kann eine solche zusätzliche Diode zur Absorption von Strahlung führen, wodurch sich die nutzbare optische Leistung des Bauelements verringert. So beschreibt die Offenlegungschrift DE 10 2005 043 649 A1 eine Leuchtdiode mit einer, in den Chip integrierten, Schutzdiode.

Es ist eine Aufgabe, einen strahlungsemittierenden Halbleiterchip anzugeben, der gegenüber elektrostatischer Entladung eine verringerte Empfindlichkeit aufweist. Weiterhin soll ein Verfahren zur Herstellung eines solchen strahlungsemittierenden Halbleiterchips angegeben werden.

Diese Aufgaben werden durch einen strahlungsemittierenden Halbleiterchip beziehungsweise ein Verfahren zur Herstellung eines strahlungsemittierenden Halbleiterchips gemäß den unabhängigen Patentansprüchen gelöst. Weitere Ausbildungen und Zweckmäßigkeiten sind Gegenstand der abhängigen Patentansprüche.

Gemäß einer Ausführungsform weist ein strahlungsemittierender Halbleiterchip einen Träger und einen Halbleiterkörper mit einer Halbleiterschichtenfolge auf. Die Halbleiterschichtenfolge weist einen zur Erzeugung von Strahlung vorgesehenen aktiven Bereich, eine erste Halbleiterschicht und eine zweite Halbleiterschicht auf. Der aktive Bereich ist zwischen der ersten Halbleiterschicht und der zweiten Halbleiterschicht angeordnet. Die erste Halbleiterschicht ist auf der dem Träger abgewandten Seite des aktiven Bereichs angeordnet. Der Halbleiterkörper weist zumindest eine Ausnehmung auf, die sich durch den aktiven Bereich hindurch erstreckt. Die erste Halbleiterschicht ist elektrisch leitend mit einer ersten Anschlussschicht verbunden, wobei sich die erste Anschlussschicht in der Ausnehmung von der ersten Halbleiterschicht in Richtung des Trägers erstreckt. Die erste Anschlussschicht ist mit der zweiten Halbleiterschicht über eine Schutzdiode elektrisch verbunden.

Bei einem Halbleiterchip gemäß dieser Ausführungsform ist die Schutzdiode in den Halbleiterchip integriert. Die Gefahr einer Schädigung des Halbleiterchips, etwa aufgrund von elektrostatischer Entladung ist somit verringert. Auf eine zusätzliche, außerhalb des Halbleiterchips anzuordnende und mit diesem elektrisch leitend zu verbindende Schutzdiode kann verzichtet werden.

Über die Schutzdiode kann insbesondere eine unerwünschte, etwa in Sperrrichtung des Halbleiterchips beziehungsweise eines hierin gebildeten strahlungserzeugenden pn-Übergangs an diesem anliegende, Spannung abfließen. Die Schutzdiode kann insbesondere die Funktion einer ESD (Electrostatic Discharge)-Diode erfüllen, die den Halbleiterchip vor einer Schädigung durch elektrostatische Entladung schützt. Mit anderen Worten können Ladungsträger über einen Strompfad zwischen der ersten Anschlussschicht und der zweiten Halbleiterschicht abfließen. Die Gefahr einer Schädigung des Halbleiterchips kann so verringert werden.

Die erste Halbleiterschicht und die zweite Halbleiterschicht des Halbleiterkörpers sind zweckmäßigerweise bezüglich ihres Leitungstyps voneinander verschieden. Beispielsweise kann die erste Halbleiterschicht p-leitend und die zweite Halbleiterschicht n-leitend ausgebildet sein oder umgekehrt.

Eine Diodenstruktur, in der der aktive Bereich ausgebildet ist, ist so auf einfache Weise realisiert.

In einer bevorzugten Ausgestaltung ist die Schutzdiode zwischen der ersten Anschlussschicht und der zweiten Halbleiterschicht ausgebildet. Die Schutzdiode kann so auf einfache Weise in einem Strompfad zwischen der ersten Anschlussschicht und der zweiten Halbleiterschicht angeordnet sein.

Weiterhin kann die Schutzdiode außerhalb des Trägers ausgebildet sein. Das Ausbilden der Schutzdiode kann somit weitgehend unabhängig von den Eigenschaften des Trägers, insbesondere der elektrischen Leitfähigkeit oder der elektrischen Kontaktierbarkeit, erfolgen.

Der Halbleiterchip weist weiterhin bevorzugt einen ersten Kontakt und einen zweiten Kontakt auf, die jeweils für die externe elektrische Kontaktierung des Halbleiterchips vorgesehen sind.

Eine zwischen dem ersten Kontakt und dem zweiten Kontakt anliegende Betriebsspannung bewirkt eine Injektion von Ladungsträgern von verschiedenen Seiten des aktiven Bereichs in den aktiven Bereich. Die injizierten Ladungsträger können unter Emission von Strahlung im aktiven Bereich rekombinieren.

Bezüglich der Durchlassrichtung sind die Diodenstruktur des Halbleiterkörpers und die Schutzdiode zweckmäßigerweise antiparallel zueinander ausgebildet.

Durch die Schutzdiode, welche bei der Betriebsspannung des Halbleiterchips in Sperr-Richtung betrieben wird, erfolgt in diesem Fall kein oder zumindest kein wesentlicher Stromfluss. Dagegen kann eine in Sperr-Richtung an der Diodenstruktur anliegende elektrische Spannung, etwa aufgrund elektrostatischer Aufladung, über die Schutzdiode abfließen. So kann der Halbleiterkörper, insbesondere der aktive Bereich, durch die in den Halbleiterchip integrierte Schutzdiode geschützt werden.

In einer bevorzugten Ausgestaltung ist die Schutzdiode als eine Schottky-Diode ausgeführt. Eine Schottky-Diode kann insbesondere mittels eines Metall-Halbleiter-Übergangs gebildet sein, wobei die Strom-Spannungs-Kennlinie des Übergangs von einer Ohmschen Charakteristik abweicht und insbesondere bezüglich der Polarität der anliegenden Spannung asymmetrisch verläuft.

In einer bevorzugten Ausgestaltung überlappt die Schutzdiode in Aufsicht auf den Halbleiterchip mit dem Halbleiterkörper. Der Halbleiterkörper, insbesondere der aktive Bereich, kann die Schutzdiode in Aufsicht vollständig überdecken. Die Schutzdiode ist somit bei gleicher lateraler Ausdehnung des Halbleiterkörpers in den Halbleiterchip integrierbar. Weiterhin ist so die Schutzdiode unter Beibehaltung der für die Strahlungserzeugung nutzbaren Fläche des aktiven Bereichs in den Halbleiterchip integrierbar.

Unter einer lateralen Richtung wird eine Richtung verstanden, die entlang einer Haupterstreckungsebene der Halbleiterschichten des Halbleiterkörpers verläuft.

In einer bevorzugten Weiterbildung ist die Schutzdiode mittels der zweiten Halbleiterschicht gebildet. Die zweite Halbleiterschicht kann also sowohl für die Injektion von Ladungsträgern in den aktiven Bereich als auch für das Ausbilden der Schutzdiode vorgesehen sein. Auf einen separaten, elektrisch vom aktiven Bereich isolierten, Halbleiterbereich für das Ausbilden der Schottky-Diode kann so verzichtet werden. Mit anderen Worten kann die Schutzdiode, insbesondere in Form einer Schottky-Diode, bei gleicher lateraler Ausdehnung des Halbleiterchips in den Halbleiterchip integriert sein, ohne dass die für die Strahlungserzeugung maßgebliche Fläche des aktiven Bereichs verringert wird. Die Integration der Schutzdiode in den Halbleiterchip kann somit ohne eine Beeinträchtigung der optoelektronischen Eigenschaften des Halbleiterchips erfolgen.

In einer bevorzugten Ausgestaltung verläuft die erste Anschlussschicht zumindest bereichsweise zwischen dem Träger und der zweiten Halbleiterschicht. Mittels der ersten Anschlussschicht ist die erste Halbleiterschicht von der dem Träger zugewandten Seite des aktiven Bereichs her elektrisch kontaktierbar.

In einer bevorzugten Weiterbildung ist zumindest bereichsweise zwischen der ersten Anschlussschicht und der zweiten Halbleiterschicht eine zweite Anschlussschicht angeordnet. Die zweite Anschlussschicht ist elektrisch leitend mit der zweiten Halbleiterschicht verbunden und grenzt weiterhin bevorzugt unmittelbar an die zweite Halbleiterschicht an.

Zweckmäßigerweise sind die erste Anschlussschicht und die zweite Anschlussschicht jeweils über den ersten beziehungsweise zweiten Kontakt extern elektrisch kontaktierbar. Der erste und/oder der zweite Kontakt können jeweils mittels einer Kontaktschicht gebildet sein, die, vorzugsweise unmittelbar, auf der ersten beziehungsweise zweiten Anschlussschicht angeordnet ist. Davon abweichend kann die erste Anschlussschicht den ersten Kontakt und/oder die zweite Anschlussschicht den zweiten Kontakt bilden. In diesem Fall kann also zumindest auf eine separate, zusätzlich zu den Anschlussschichten vorgesehene und den ersten beziehungsweise zweiten Kontakt bildende, Kontaktschicht verzichtet werden.

Die erste Anschlussschicht und/oder die zweite Anschlussschicht enthalten vorzugsweise jeweils ein Metall, beispielsweise Ti, Pt, Ni, Au, Ag, Al, Rh, Pd, Pt oder W oder eine metallische Legierung mit zumindest einem der genannten Materialien. Die erste und/oder die zweite Anschlussschicht sind vorzugsweise außerhalb des Halbleiterkörpers angeordnet und mittels eines nicht-epitaktischen Verfahrens, etwa Aufdampfens oder Sputterns, hergestellt.

In einer Ausgestaltungsvariante ist die Schutzdiode mittels einer Übergangsschicht gebildet, die auf der zweiten Halbleiterschicht angeordnet ist und weiterhin bevorzugt an die zweite Halbleiterschicht angrenzt. Die Übergangsschicht und die zweite Anschlussschicht sind zweckmäßigerweise in lateraler Richtung voneinander beabstandet. Ein direkter elektrischer Kontakt zwischen der Übergangsschicht und der zweiten Anschlussschicht ist so auf einfache Weise vermeidbar.

Weiterhin bevorzugt ist zwischen der Übergangsschicht und der zweiten Anschlussschicht eine Isolationsschicht ausgebildet. Die Gefahr eines elektrischen Kurzschlusses zwischen der Übergangsschicht und der zweiten Anschlussschicht kann so weitergehend verringert werden.

Die Übergangsschicht ist bezüglich des Materials vorzugsweise derart gewählt, dass ein Schottky-Übergang, also ein Metall-Halbleiter-Übergang mit asymmetrischer Strom-Spannungs-Charakteristik, zur zweiten Halbleiterschicht vereinfacht realisierbar ist.

In einer alternativen Ausgestaltungsvariante ist die Schutzdiode mittels der ersten Anschlussschicht gebildet, wobei die erste Anschlussschicht vorzugsweise an die zweite Halbleiterschicht angrenzt. In diesem Fall grenzt die erste Anschlussschicht also an die erste Halbleiterschicht und an die zweite Halbleiterschicht an, wobei zwischen der ersten Anschlussschicht und der ersten Kontaktschicht ein Ohm'scher oder zumindest näherungsweise Ohm'scher Kontakt und zwischen der ersten Anschlussschicht und der zweiten Kontaktschicht ein Schottky-Kontakt gebildet ist.

Das Material für die an die zweite Halbleiterschicht angrenzende Schicht, also die Übergangsschicht oder die erste Anschlussschicht, ist vorzugsweise derart gewählt, dass ein Schottky-Kontakt zur zweiten Halbleiterschicht vereinfacht ausgebildet werden kann.

In einer bevorzugten Weiterbildung weist die zweite Halbleiterschicht zumindest bereichsweise, insbesondere im Bereich der Schutzdiode, eine lokal gezielt verringerte Kontaktfähigkeit auf. Ein solcher Bereich verringerter Kontaktfähigkeit ist beispielsweise mittels Veraschens, etwa in einem Sauerstoffhaltigen Plasma, oder Sputterns herstellbar. Auf diese Weise kann die elektrische Leitfähigkeit der zweiten Halbleiterschicht gezielt verringert werden.

So kann zwischen der zweiten Halbleiterschicht und der Übergangsschicht beziehungsweise der ersten Anschlussschicht ein Kontakt mit einer hinreichend hohen Potenzial-Barriere vereinfacht realisiert werden. Die Freiheit bezüglich des Materials der an die zweite Halbleiterschicht angrenzenden Schicht, also der Übergangsschicht oder der ersten Anschlussschicht, ist so weitergehend erhöht. Insbesondere kann die Schicht ein Material enthalten oder aus einem Material bestehen, das für die im aktiven Bereich erzeugte Strahlung eine hohe Reflektivität aufweist. Für Strahlung im sichtbaren oder im ultravioletten Spektralbereich zeichnen sich beispielsweise Silber oder Aluminium durch eine hohe Reflektivität auf.

In einer Ausgestaltungsvariante sind der erste Kontakt und der zweite Kontakt auf unterschiedlichen Seiten des Trägers ausgebildet. In diesem Fall ist der Träger vorzugsweise elektrisch leitfähig ausgebildet.

In einer alternativen Ausgestaltungsvariante sind der erste Kontakt und der zweite Kontakt auf der dem Halbleiterkörper zugewandten Seite des Trägers angeordnet. In diesem Fall kann der Träger unabhängig von seiner elektrischen Leitfähigkeit gewählt werden und insbesondere elektrisch isolierend ausgebildet sein.

Als elektrisch leitfähiges Trägermaterial eignet sich beispielsweise ein, vorzugsweise dotiertes, Halbleitermaterial. Zum Beispiel kann der Träger Silizium, Germanium, Galliumarsenid oder Galliumnitrid enthalten oder aus einem solchen Material bestehen.

Weiterhin eignet sich als Trägermaterial beispielsweise eine Keramik, etwa Aluminiumnitrid oder Bornitrid. Ein solcher Träger kann elektrisch isolierend ausgebildet sein.

Der Halbleiterkörper ist vorzugsweise stoffschlüssig mit dem Träger verbunden. Der Träger ist insbesondere von einem Aufwachssubstrat für die Halbleiterschichtenfolge des Halbleiterkörpers verschieden. Der Träger stabilisiert vorzugsweise die Halbleiterschichtenfolge des Halbleiterkörpers mechanisch. Das Aufwachssubstrat des Halbleiterkörpers ist hierfür nicht erforderlich und kann entfernt sein.

Bei einer stoffschlüssigen Verbindung werden die Verbindungspartner, die bevorzugt vorgefertigt sind, mittels atomarer und/oder molekularer Kräfte zusammengehalten. Eine stoffschlüssige Verbindung kann beispielsweise mittels einer Verbindungsschicht, etwa einer Klebeschicht oder einer Lotschicht, erzielt werden. In der Regel geht eine Trennung der Verbindung mit der Zerstörung der Verbindungsschicht und/oder zumindest eines der Verbindungspartner einher.

In einer bevorzugten Weiterbildung ist das Aufwachssubstrat für die Halbleiterschichtenfolge des Halbleiterkörpers zumindest bereichsweise entfernt. Insbesondere kann das Aufwachssubstrat vollflächig oder bereichsweise gedünnt oder vollflächig oder bereichsweise entfernt sein.

Ein Halbleiterchip, bei dem das Aufwachssubstrat entfernt ist, wird auch als Dünnfilm-Halbleiterchip bezeichnet.

Ein Dünnfilm-Halbleiterchip, etwa ein Dünnfilm-Leuchtdioden-Chip, kann sich weiterhin im Rahmen der vorliegenden Anmeldung durch mindestens eines der folgenden charakteristischen Merkmale auszeichnen:
- an einer zu einem Trägerelement hin gewandten ersten Hauptfläche eines Halbleiterkörpers, der eine Halbleiterschichtenfolge mit einem aktiven Bereich umfasst, insbesondere einer Epitaxieschichtenfolge, ist eine Spiegelschicht aufgebracht oder, etwa als Braggspiegel in der Halbleiterschichtenfolge integriert, ausgebildet, die zumindest einen Teil der in der Halbleiterschichtenfolge erzeugten Strahlung in diese zurückreflektiert;
- die Halbleiterschichtenfolge weist eine Dicke im Bereich von 20pm oder weniger, insbesondere im Bereich von 10 µm auf; und/oder
- die Halbleiterschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der Halbleiterschichtenfolge führt, d.h. sie weist ein möglichst ergodisch stochastisches Streuverhalten auf. Ein Grundprinzip eines Dünnfilm-Leuchtdiodenchips ist beispielsweise in I. Schnitzer et al., Appl. Phys. Lett. 63 (16), 18. Oktober 1993, 2174 - 2176 beschrieben.

Die Halbleiterschichtenfolge des Halbleiterkörpers ist vorzugsweise epitaktisch, etwa mittels MOVPE oder MBE, abgeschieden.

Weiterhin bevorzugt enthält der Halbleiterkörper, insbesondere der aktive Bereich, ein III-V-Halbleitermaterial. Mit III-V-Halbleitermaterialen können bei der Strahlungserzeugung hohe interne Quanteneffizienzen erreicht werden.

Der beschriebene Aufbau ist generell für optoelektronische Halbleiterchips geeignet, die zur Strahlungserzeugung und/oder zur Detektion von Strahlung vorgesehen sind. Insbesondere kann der Halbleiterchip zur Erzeugung von inkohärenter, teilkohärenter oder kohärenter Strahlung vorgesehen sein. Zur Erzeugung inkohärenter Strahlung eignet sich beispielsweise ein Aufbau gemäß einem LED-Chip, für die Erzeugung teilkohärenter Strahlung ein Aufbau gemäß einem RCLED-Chip (Resonant Cavity Light Emitting Diode). Kohärente Strahlung kann beispielsweise mittels eines Halbleiterlaser-Chips erzeugt werden, der insbesondere als
kantenemittierender Laser oder als oberflächenemittierender Laser, etwa als VCSEL (vertical cavity surface emitting laser) oder als VECSEL (vertical external cavity surface emitting laser) ausgeführt sein kann.

Bei einem Verfahren zur Herstellung eines
strahlungsemittierenden Halbleiterchips wird gemäß einer Ausführungsform ein Halbleiterkörper mit einer Halbleiterschichtenfolge bereitgestellt, die einen zur Erzeugung von Strahlung vorgesehenen aktiven Bereich, eine erste Halbleiterschicht und eine zweite Halbleiterschicht aufweist. Im Halbleiterkörper wird eine Ausnehmung ausgebildet, die sich durch den aktiven Bereich hindurch in die erste Halbleiterschicht hinein erstreckt. Auf dem Halbleiterkörper wird eine erste Anschlussschicht ausgebildet, wobei sich die erste Anschlussschicht in die Ausnehmung hinein erstreckt. Die erste Anschlussschicht ist mit der zweiten Halbleiterschicht über eine Schutzdiode elektrisch verbunden. Der Halbleiterchip wird fertig gestellt.

Die Verfahrensschritte müssen hierbei nicht notwendigerweise in der Reihenfolge der obigen Aufzählung durchgeführt werden.

Ein Verfahren, bei dem eine Schutzdiode in den Halbleiterchip integriert werden kann, ist so auf einfache und kostengünstige Weise realisiert. Mit diesem Verfahren können eine Vielzahl von Halbleiterchips gleichzeitig, insbesondere nebeneinander auf einem Wafer, hergestellt werden. Bei diesem Verfahren können durch Vereinzelung Halbleiterchips hervorgehen, in die bereits eine Schutzdiode integriert ist.

Die Integration der Schutzdiode kann somit auf Wafer-Ebene, also noch vor Vereinzelung der Halbleiterchips erfolgen.

In einer bevorzugten Ausgestaltung wird vor dem Ausbilden der ersten Anschlussschicht auf der zweiten Halbleiterschicht eine Übergangsschicht ausgebildet, die an die zweite Halbleiterschicht angrenzt. Insbesondere kann mittels der Übergangsschicht eine Schottky-Diode ausgebildet werden.

In einer bevorzugten Weiterbildung wird die elektrische Kontaktfähigkeit der zweiten Halbleiterschicht gezielt lokal verringert. Dies kann insbesondere vor dem Abscheiden der Übergangsschicht erfolgen.

Insbesondere kann die elektrische Kontaktfähigkeit mittels Veraschens und/oder mittels Sputterns verringert werden.

In einer weiteren bevorzugten Ausgestaltung wird die zweite Anschlussschicht mittels bereichsweisen Entfernens des Halbleiterkörpers freigelegt. In dem freigelegten Bereich der zweiten Anschlussschicht kann ein Kontakt ausgebildet werden, der zur elektrischen Kontaktierung des Halbleiterchips vorgesehen ist.

Das beschriebene Verfahren ist zur Herstellung eines weiter oben beschriebenen strahlungsemittierenden Halbleiterchips besonders geeignet. Die im Zusammenhang mit dem Verfahren beschriebenen Merkmale können daher auch für den Halbleiterchip herangezogen werden und umgekehrt.

Weitere Merkmale, Ausgestaltungen und Zweckmäßigkeiten ergeben sich aus der folgenden Beschreibung der Ausführungsbeispiele in Verbindung mit den Figuren.

Es zeigen:
- Die Figuren 1A und 1B: ein Ausführungsbeispiel für einen strahlungsemittierenden Halbleiterchip in schematischer Aufsicht (Figur 1B) und zugehöriger Schnittansicht (Figur 1A);
- Figur 2: eine schematische Darstellung der Strompfade in einem Halbleiterchip gemäß dem in den Figuren 1A und 1B dargestellten ersten Ausführungsbeispiel; und
- die Figuren 3A bis 3F: ein Ausführungsbeispiel für ein Verfahren zur Herstellung eines strahlungsemittierenden Halbleiterchips anhand von jeweils in schematischer Schnittansicht dargestellten Zwischenschritten.

Gleiche, gleichartige oder gleich wirkende Elemente sind in den Figuren mit gleichen Bezugszeichen versehen.

Die Figuren sind jeweils schematische Darstellungen und daher nicht unbedingt maßstabsgetreu. Vielmehr können vergleichsweise kleine Elemente und insbesondere Schichtdicken zur Verdeutlichung übertrieben groß dargestellt sein.

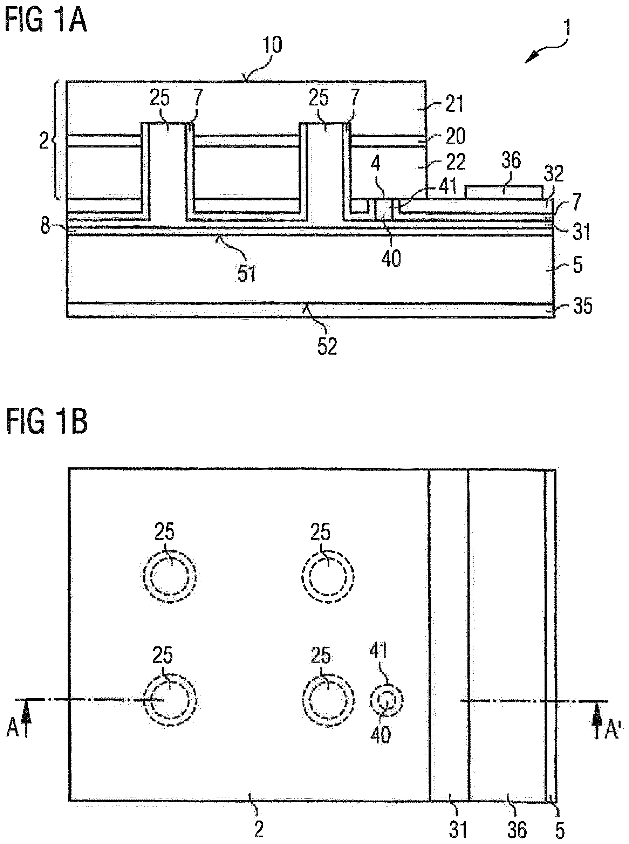

Ein erstes Ausführungsbeispiel für einen
strahlungsemittierenden Halbleiterchip ist schematisch anhand einer Aufsicht in Figur 1B und einer zugehörigen Schnittansicht entlang der Linie AA' in Figur 1A gezeigt.

Der strahlungsemittierende Halbleiterchip 1 weist einen Halbleiterkörper 2 auf, der mittels einer Verbindungsschicht 8 an einem Träger 5 befestigt ist.

Die Halbleiterschichtenfolge, die den Halbleiterkörper 2 bildet, ist vorzugsweise epitaktisch, etwa mittels MOVPE oder MBE, hergestellt.

Der Halbleiterkörper weist einen zur Erzeugung von Strahlung vorgesehenen aktiven Bereich 20 auf, der zwischen einer ersten Halbleiterschicht 21 und einer zweiten Halbleiterschicht 22 angeordnet ist. Die erste Halbleiterschicht 21 und die zweite Halbleiterschicht 22 sind bezüglich ihres Leitungstyps voneinander verschieden. Beispielsweise kann die zweite Halbleiterschicht 22 p-leitend und die erste Halbleiterschicht 21 n-leitend ausgebildet sein oder umgekehrt.

Der Halbleiterkörper 2 weist eine Mehrzahl von Ausnehmungen 25 auf, die sich vom Träger 5 her durch die zweite Halbleiterschicht 22 und den aktiven Bereich 20 in die erste Halbleiterschicht 21 hinein erstrecken.

Die Ausnehmungen 25 sind exemplarisch in Aufsicht jeweils kreisförmig ausgebildet und matrixförmig angeordnet. Die Ausnehmungen können aber auch eine andere Grundform, etwa eine mehreckige, beispielsweise rechteckige oder quadratische Grundform aufweisen. Die Ausnehmungen sind zweckmäßigerweise derart angeordnet, dass Ladungsträger in lateraler Richtung gleichmäßig von der ersten Halbleiterschicht 21 in den aktiven Bereich injiziert werden können. Insbesondere bei einer hinreichend hohen elektrischen Leitfähigkeit der ersten Halbleiterschicht 21 in lateraler Richtung kann von dem beschriebenen Ausführungsbeispiel abweichend auch nur eine einzelne Ausnehmung vorgesehen sein.

Der Träger 5 weist eine erste Hauptfläche 51 und eine weitere Hauptfläche 52 auf. Die erste Hauptfläche 51 ist dem Halbleiterkörper 2 zugewandt und vorzugsweise eben ausgeführt. Eine stoffschlüssige Befestigung des Halbleiterkörpers an dem Träger ist so vereinfacht realisierbar.

Als Trägermaterial eignet sich beispielsweise ein, vorzugsweise dotiertes, Halbleitermaterial. Zum Beispiel kann der Träger Silizium, Germanium, Galliumarsenid oder Galliumnitrid enthalten oder aus einem solchen Material bestehen. Alternativ oder ergänzend kann der Träger eine Keramik, etwa AlN oder BN enthalten.

Zwischen dem Halbleiterkörper 2 und dem Träger 5 ist eine erste Anschlussschicht 31 ausgebildet, die sich in die Ausnehmungen 25 hinein erstreckt. Mittels der ersten Anschlussschicht ist die erste Halbleiterschicht 21 von der dem Träger zugewandten Seite des aktiven Bereichs 20 her elektrisch kontaktierbar.

Eine dem Träger 5 abgewandte Strahlungsaustrittsfläche 10 des Halbleiterkörpers 2 kann so frei von einem externen elektrischen Kontakt ausgebildet werden. Die Gefahr einer Abschattung der Strahlungsaustrittsfläche durch einen Kontakt, der für die im aktiven Bereich erzeugte Strahlung undurchlässig ist, kann vermieden werden.

Die Seitenflächen der Ausnehmungen 25 sind mit einer Isolationsschicht 7 versehen. Ein elektrischer Kurzschluss des aktiven Bereichs 20 durch die erste Anschlussschicht 31 kann auf einfache Weise verhindert werden.

Die Isolationsschicht 7 kann beispielsweise ein Nitrid, etwa Siliziumnitrid, ein Oxid, etwa Siliziumoxid oder Titanoxid, oder ein Oxinitrid, etwa Siliziumoxinitrid, enthalten oder aus einem solchen Material bestehen.

Die zweite Halbleiterschicht 22 ist mit einer zweiten Anschlussschicht 32 elektrisch leitend verbunden. Die zweite Anschlussschicht verläuft bereichsweise zwischen der ersten Anschlussschicht 31 und der zweiten Halbleiterschicht 22.

Weiterhin weist der Halbleiterchip 1 einen ersten Kontakt 35 und einen zweiten Kontakt 36 auf. Die Kontakte sind zur externen elektrischen Kontaktierung des Halbleiterchips vorgesehen und dienen der Injektion von Ladungsträgern von verschiedenen Seiten des aktiven Bereichs 20 in den aktiven Bereich, so dass die injizierten Ladungsträger im aktiven Bereich unter Emission von Strahlung rekombinieren können.

Mittels der ersten Anschlussschicht 31 und der zweiten Anschlussschicht 32 ist der Halbleiterkörper von derselben Seite des Halbleiterkörpers her derart elektrisch kontaktierbar, dass Ladungsträger im Betrieb in den aktiven Bereich 20 verschiedenen Seiten injiziert werden können. Auf diese Weise ist vereinfacht ein Halbleiterchip realisierbar, dessen Strahlungsaustrittsfläche frei von externen elektrischen Kontakten ist.

Der erste Kontakt 35 ist über den Träger 5 und die Verbindungsschicht 8 mit der ersten Anschlussschicht 31 elektrisch leitend verbunden. Der zweite Kontakt 36 ist auf der zweiten Anschlussschicht 32 angeordnet und mit dieser elektrisch leitend verbunden.

Zwischen der ersten Anschlussschicht 31 und der zweiten Halbleiterschicht 22 ist eine Schutzdiode 4 ausgebildet.

Die Schutzdiode 4 ist mittels einer Übergangsschicht 40 gebildet, die sich von der zweiten Halbleiterschicht 22 in vertikaler Richtung bis zur ersten Anschlussschicht 31 erstreckt. Die Schutzdiode 4 ist als eine Schottky-Diode ausgeführt, bei der die Übergangsschicht 40 und die zweite Halbleiterschicht 22 einen Metall-Halbleiter-Übergang bilden.

In Aufsicht auf den Halbleiterchip 1 überdeckt der Halbleiterkörper 2, insbesondere der aktive Bereich 20, die Schutzdiode 4 vollständig. Die Schutzdiode ist also derart in den Halbleiterkörper integriert, dass sowohl die für die Strahlungserzeugung nutzbare Fläche als auch die laterale Ausdehnung des Halbleiterchips beibehalten werden kann.

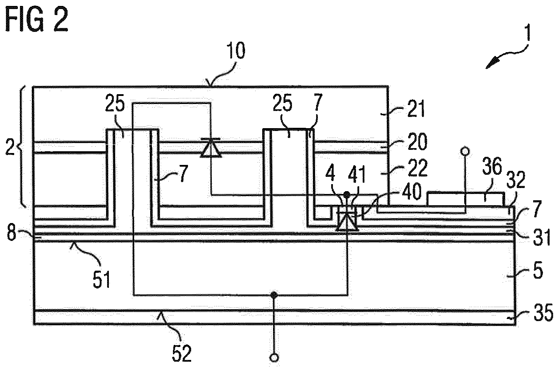

Bezüglich des Materials ist die Übergangsschicht vorzugsweise derart gewählt, dass eine im Betrieb des Halbleiterchips 1 in Vorwärtsrichtung anliegende Betriebsspannung zu keinem oder zumindest keinen wesentlichen Stromfluss zwischen der ersten Anschlussschicht 31 und der zweiten Halbleiterschicht 22 führt. Die Strompfade innerhalb des Halbleiterchips werden im Zusammenhang mit Figur 2 näher erläutert.

Bei einem Halbleiterkörper, der Inₓ Ga_{y} Al_{1-x-y} N mit 0 ≤ x ≤ 1, 0 ≤ y ≤ 1 und x + y ≤ 1, insbesondere mit x ≠ 1, y ≠ 1, x ≠ 0 und/oder y ≠ 0 enthält, eignet sich beispielsweise eine Übergangsschicht, die TiWN enthält oder aus einer solchen Materialzusammensetzung besteht.

Alternativ oder ergänzend kann die Übergangsschicht 40 als eine hochreflektive Metallschicht ausgebildet sein. Beispielsweise weisen Silber und Aluminium eine hohe Reflektivität im sichtbaren und ultravioletten Spektralbereich auf. Im aktiven Bereich erzeugte und in Richtung des Trägers 5 abgestrahlte Strahlung kann so auf effiziente Weise in Richtung der Strahlungsaustrittsfläche umgelenkt werden.

In der zweiten Anschlussschicht 32 ist eine Aussparung 41 ausgebildet. Durch diese Aussparung hindurch erstreckt sich die Übergangsschicht 40. Die Seitenflächen der Aussparung 41 sind mit der Isolationsschicht 7 bedeckt. Ein elektrischer Kurzschluss zwischen der Übergangsschicht 40 und der zweiten Anschlussschicht 32 kann so vermieden werden.

Die Anschlussschichten 31 und 32 enthalten vorzugsweise jeweils ein Metall, etwa Ti, Pt, Ni, Au, Ag, Al, Rh, Pd, Pt oder W oder eine metallische Legierung mit zumindest einem der genannten Metalle.

Die erste Anschlussschicht 35 und/oder die zweite 36 Anschlussschicht können auch mehrschichtig ausgeführt sein.

Weiterhin können die erste Anschlussschicht 31 und/oder die zweite Anschlussschicht 32 auch ein TCO (Transparent conductive oxide)-Material, etwa Zinkoxid, Indiumoxid oder Indiumzinnoxid (ITO) enthalten.

Der Halbleiterkörper 2, insbesondere der aktive Bereich 20, enthält vorzugsweise ein III-V-Halbleitermaterial.

III-V-Halbleitermaterialien sind zur Strahlungserzeugung im ultravioletten (Inₓ Ga_{y} Al_{1-x-y} N) über den sichtbaren (Inₓ Ga_{y} Al_{1-x-y} N, insbesondere für blaue bis grüne Strahlung, oder Inₓ Ga_{y} Al_{1-x-y} P, insbesondere für gelbe bis rote Strahlung) bis in den infraroten (Inₓ Ga_{y} Al_{1-x-y} As) Spektralbereich besonders geeignet. Hierbei gilt jeweils 0 ≤ x ≤ 1, 0 ≤ y ≤ 1 und x + y ≤ 1, insbesondere mit x ≠ 1, y ≠ 1, x ≠ 0 und/oder y ≠ 0. Mit III-V-Halbleitermaterialien, insbesondere aus den genannten Materialsystemen, können weiterhin bei der Strahlungserzeugung hohe interne Quanteneffizienzen erzielt werden.

Weiterhin kann die Schutzdiode 4 von dem gezeigten Ausführungsbeispiel abweichend auch mittels der ersten Anschlussschicht 31 gebildet sein, wobei die erste Anschlussschicht an die zweite Halbleiterschicht 22 angrenzt. Auf eine separate, zusätzlich zur ersten Anschlussschicht 31 vorgesehene Übergangsschicht kann in diesem Fall verzichtet werden. Die erste Anschlussschicht 31 kann also zum Halbleiterkörper 2 zum einen einen Ohmschen Kontakt zur ersten Halbleiterschicht 21 bilden und zum anderen über einen Schottky-Kontakt mit der zweiten Halbleiterschicht 22 elektrisch verbunden sein.

Auch eine Anordnung, bei der die erste Anschlussschicht und die Übergangsschicht voneinander beabstandet ausgeführt sind, ist denkbar, sofern die Anschlussschicht und die Übergangsschicht, beispielsweise über den Träger oder über die Verbindungsschicht, elektrisch leitend verbunden sind.

Ferner kann die elektrische Kontaktfähigkeit der zweiten Halbleiterschicht bereichsweise, insbesondere im Bereich der Schutzdiode 4, gezielt lokal verringert sein (in Figur 1A nicht explizit dargestellt). Die Freiheit in der Wahl des Materials für die an die zweite Halbleiterschicht 22 angrenzende Schicht, also die Übergangsschicht 40 oder die erste Anschlussschicht 31, ist so vergrößert.

Von dem beschriebenen Ausführungsbeispiel abweichend können die Kontakte 35 und 36 auch auf derselben Seite des Trägers 5, insbesondere auf der ersten Hauptfläche 51 angeordnet sein. In diesem Fall kann der Träger 5 auch elektrisch isolierend ausgeführt sein.

In dem gezeigten Ausführungsbeispiel ist der Halbleiterchip 1 als ein Dünnfilm-Halbleiterchip ausgeführt, bei dem das Aufwachssubstrat die Halbleiterschichtenfolge des Halbleiterkörpers 2 entfernt ist. Davon abweichend kann das Aufwachssubstrat aber auch nur bereichsweise entfernt oder vollflächig oder bereichsweise gedünnt sein.

Ferner kann der Halbleiterchip auch als RCLED oder als ein Halbleiterlaser-Chip, insbesondere als ein VCSEL oder als ein VECSEL, ausgeführt sein.

Die Strompfade in dem Halbleiterchip 1 sind in Figur 2 schematisch dargestellt. Hierbei ist die erste Halbleiterschicht 21 und der Träger 5 exemplarisch n-leitend dotiert und die zweite Halbleiterschicht 22 p-leitend dotiert.

Bei Anliegen einer positiven elektrischen Spannung an dem zweiten Kontakt 36 relativ zum ersten Kontakt 35 wird die zur Erzeugung von Strahlung vorgesehene Diodenstruktur des Halbleiterkörpers 2 in Durchlassrichtung betrieben, so dass Ladungsträger in den aktiven Bereich 20 injiziert werden und dort unter Emissionen von Strahlung rekombinieren können.

Die Schutzdiode 4 ist bei dieser Polarität dagegen in Sperr-Richtung geschaltet. Durch die Übergangsschicht 40 fließt also kein oder zumindest kein wesentlicher Anteil des Betriebstroms zwischen den Kontakten 35, 36 des Halbleiterchips.

Im Falle einer elektrostatischen Aufladung des Halbleiterchips in Sperr-Richtung aber können Ladungsträger über den Strompfad zwischen dem ersten Kontakt 35 und dem zweiten Kontakt 36 über die Schutzdiode 4 abfließen. Ladungsträger können also unter Umgehung des aktiven Bereichs 20 von der ersten Anschlussschicht 31 über die Schutzdiode 4 in die zweite Halbleiterschicht 22 gelangen. Die zur Strahlungserzeugung vorgesehene Diodenstruktur des Halbleiterchips, insbesondere der aktive Bereich 20, wird beim Abfließen der Ladungsträger also nicht belastet.

Die Gefahr einer Schädigung des Halbleiterchips 1 kann so vermindert werden. Auf eine außerhalb des Halbleiterchips ausgebildete Schutzdiode, die antiparallel zum ersten Kontakt 35 und zweiten Kontakt 36 des Halbleiterchips geschaltet ist, kann somit verzichtet werden.

In dem alternativen Fall, dass die erste Halbleiterschicht 21 und der Träger 5 p-leitend dotiert sind und die zweite Halbleiterschicht 22 n-leitend dotiert ist, kann der Halbleiterchip entsprechend so betrieben werden, dass an dem ersten Kontakt 35 relativ zum zweiten Kontakt 36 eine positive Spannung anliegt.

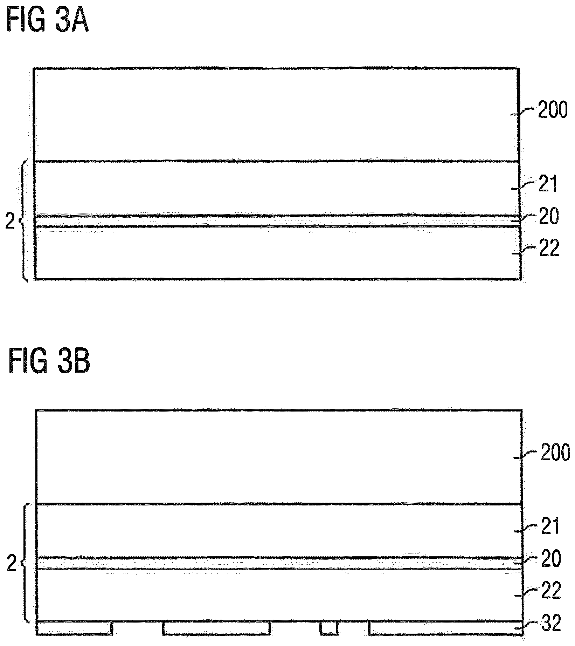

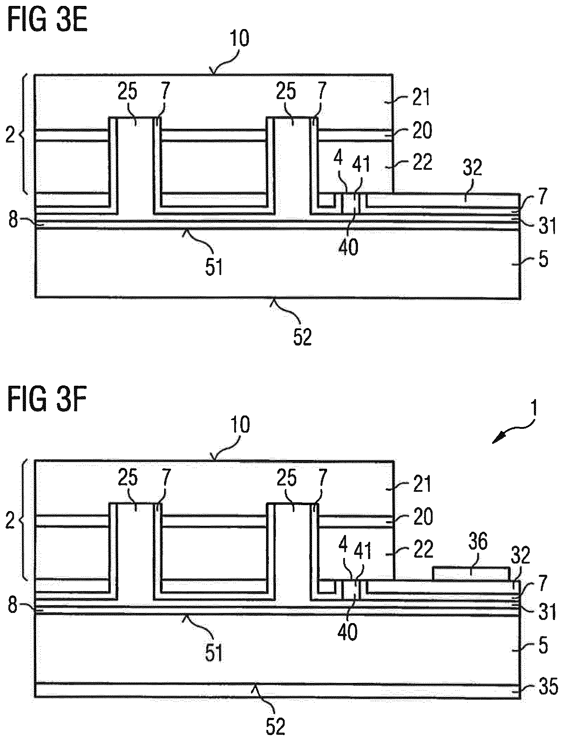

Ein Ausführungsbeispiel für ein Verfahren zur Herstellung eines strahlungsemittierenden Halbleiterchips ist in den Figuren 3A bis 3E anhand von schematisch in Schnittansicht dargestellten Zwischenschritten gezeigt.

Ein Halbleiterkörper 2, der eine Halbleiterschichtenfolge mit einem aktiven Bereich 20, eine erste Halbleiterschicht 21 und eine zweite Halbleiterschicht 22 aufweist, wird bereitgestellt. Die Halbleiterschichtenfolge, die den Halbleiterkörper 2 bildet, wird vorzugsweise epitaktisch auf einem Aufwachssubstrat 200 abgeschieden.

Wie in Figur 3B dargestellt, wird auf der zweiten Halbleiterschicht 22 eine zweite Anschlussschicht ausgebildet. Dies kann beispielsweise mittels Aufdampfens oder Aufsputterns erfolgen.

Die zweite Anschlussschicht 32 wird, beispielsweise mittels lithographischer Techniken, derart lokal strukturiert ausgebildet, dass die zweite Halbleiterschicht 22 bereichsweise freiliegt.

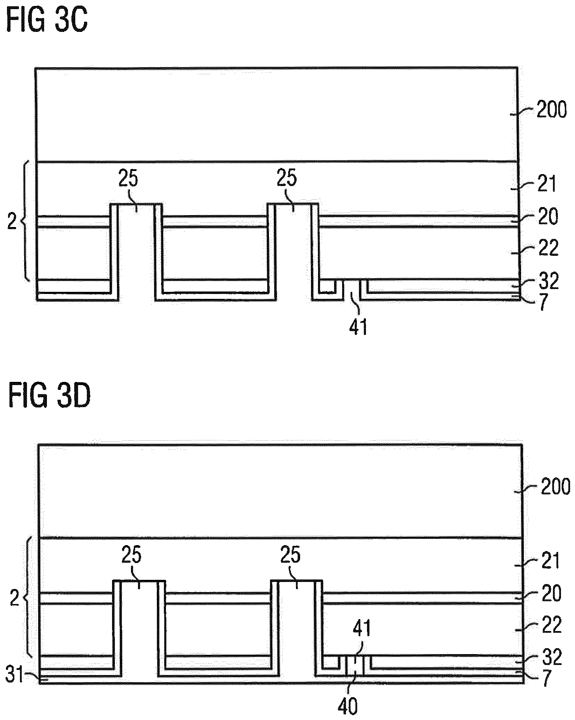

Wie in Figur 3C dargestellt, werden Ausnehmungen 25 in dem Halbleiterkörper 2 ausgebildet, die sich durch die zweite Halbleiterschicht 22 und den aktiven Bereich 20 in die erste Halbleiterschicht 21 hinein erstrecken. Nachfolgend wird der Halbleiterkörper 2 mit einer Isolationsschicht 7 versehen, welche die zweite Anschlussschicht 32 und insbesondere die Seitenflächen der Aussparung 41 und der Ausnehmungen 25 bedeckt.

In der Aussparung 41 wird eine Übergangsschicht 40 ausgebildet. Die Übergangsschicht 40 kann beispielsweise aufgedampft oder aufgesputtert werden. Wie in Figur 3D dargestellt, wird nachfolgend auf der Isolationsschicht 7 eine erste Anschlussschicht 31 abgeschieden, die sich in die Ausnehmungen 25 hinein erstreckt und die weiterhin an die Übergangsschicht 40 unmittelbar angrenzt.

Nachfolgend kann der Halbleiterkörper 2 stoffschlüssig mit einem Träger 5 verbunden werden. Dies kann mittels einer Verbindungsschicht 8 erfolgen, die beispielsweise ein Lot oder ein elektrisch leitfähiges Klebemittel enthalten kann.

Mittels des Trägers 5 kann die Halbleiterschichtenfolge des Halbleiterkörpers 2 mechanisch stabilisiert werden. Das Aufwachssubstrat 200 ist hierfür nicht mehr erforderlich und kann entfernt werden.

Das Entfernen des Aufwachssubstrats kann beispielsweise mechanisch, etwa mittels Schleifens, Polierens oder Läppens und/oder chemisch, etwa mittels nasschemischen oder trockenchemischen Ätzens, erfolgen. Alternativ oder ergänzend kann auch ein Laserablöseverfahren (laser lift-off) eingesetzt werden.

Material des Halbleiterkörpers 2 wird bereichsweise entfernt, um so die zweite Anschlussschicht 32 bereichsweise freizulegen.

Auf der dem Halbleiterkörper 2 abgewandten zweiten Hauptfläche 52 des Trägers 5 sowie auf der zweiten Anschlussschicht 32 werden ein erster Kontakt 35 beziehungsweise ein zweiter Kontakt 36 abgeschieden. Dies kann beispielsweise mittels Aufdampfens oder Aufsputterns erfolgen. Der fertig gestellte Halbleiterchip, der wie im Zusammenhang mit den Figuren 1A und 1B beschrieben ausgeführt ist, ist in Figur 3F dargestellt.

Die Integration der Schutzdiode 4 in den Halbleiterchip 1 kann bei dem beschriebenen Verfahren ohne einen wesentlichen Mehraufwand realisiert werden.

Von dem gezeigten Ausführungsbeispiel abweichend kann die elektrische Kontaktfähigkeit des Halbleiterkörpers 2, insbesondere der zweiten Halbleiterschicht 22, vor dem Abscheiden der Übergangsschicht 40 gezielt lokal verringert werden. Dies erfolgt vorzugsweise vor dem Abscheiden der ersten Anschlussschicht. Die Verringerung der Kontaktfähigkeit kann beispielsweise mittels Veraschens, etwa in einem O₂-Plasma, oder Sputterns erfolgen. So kann die elektrische Leitfähigkeit gezielt im Bereich der Aussparung 41 lokal verringert werden.

Das beschriebene Verfahren zur Herstellung wurde lediglich exemplarisch für die Herstellung eines Halbleiterchips gezeigt. Bei der Herstellung kann die
Halbleiterschichtenfolge auf einem Wafer bereitgestellt werden, wobei aus der Halbleiterschichtenfolge eine Vielzahl von Halbleiterkörpern durch Vereinzelung hervorgehen kann. Das Vereinzeln kann beispielsweise mittels Sägens, Brechens, Schneidens oder Ätzens erfolgen.

Diese Patentanmeldung beansprucht die Priorität der deutschen Patentanmeldung 10 2008 034 560.1.

Die Erfindung ist nicht durch die Beschreibungen anhand der Ausführungsbeispiele, sondern alleine durch die Ansprüche beschränkt.

## Patentansprüche

1. Strahlungsemittierender Halbleiterchip (1), der einen Träger (5) und einen Halbleiterkörper (2) mit einer Halbleiterschichtenfolge aufweist, wobei
- die Halbleiterschichtenfolge einen zur Erzeugung von Strahlung vorgesehenen aktiven Bereich (20), eine erste Halbleiterschicht (21) und eine zweite Halbleiterschicht (22) aufweist;
- der aktive Bereich (20) zwischen der ersten Halbleiterschicht (21) und der zweiten Halbleiterschicht (22) angeordnet ist;
- die erste Halbleiterschicht (21) auf der dem Träger (5) abgewandten Seite des aktiven Bereichs (20) angeordnet ist;
- der Halbleiterkörper (2) zumindest eine Ausnehmung (25) aufweist, die sich durch den aktiven Bereich (20) hindurch erstreckt;
- die erste Halbleiterschicht (21) elektrisch leitend mit einer ersten Anschlussschicht (31) verbunden ist, wobei sich die erste Anschlussschicht (31) in der Ausnehmung (25) von der ersten Halbleiterschicht (21) in Richtung des Trägers (5) erstreckt; und
- die erste Anschlussschicht (31) mit der zweiten Halbleiterschicht (22) über eine Schutzdiode (4) elektrisch verbunden ist; und
zumindest bereichsweise zwischen der ersten Anschlussschicht (31) und der zweiten Halbleiterschicht (22) eine zweite Anschlussschicht (32) angeordnet ist, die mit der zweiten Halbleiterschicht (22) elektrisch leitend verbunden ist.

2. Strahlungsemittierender Halbleiterchip nach Anspruch 1, bei dem die erste Anschlussschicht (31) zumindest
bereichsweise zwischen dem Träger (5) und der zweiten Halbleiterschicht (22) verläuft.

3. Strahlungsemittierender Halbleiterchip nach Anspruch 1 oder 2,
bei dem die Schutzdiode (4) als eine Schottky-Diode ausgeführt ist.

4. Strahlungsemittierender Halbleiterchip nach einem der Ansprüche 1 bis 3,
bei dem die Schutzdiode (4) in Aufsicht auf den Halbleiterchip (1) mit dem Halbleiterkörper (2) überlappt.

5. Strahlungsemittierender Halbleiterchip nach einem der Ansprüche 1 bis 4,
bei dem die Schutzdiode (4) mittels der zweiten Halbleiterschicht gebildet ist.

6. Strahlungsemittierender Halbleiterchip nach einem der Ansprüche 1 bis 5,
bei dem eine dem Träger abgewandte Strahlungsaustrittsfläche (10) des Halbleiterkörpers frei von einem externen elektrischen Kontakt ist.

7. Strahlungsemittierender Halbleiterchip nach einem der vorhergehenden Ansprüche,
bei dem die Schutzdiode (4) mittels einer Übergangsschicht (40) gebildet ist, die an die zweite Halbleiterschicht (22) angrenzt, wobei zwischen der Übergangsschicht (40) und der zweiten Anschlussschicht (32) eine Isolationsschicht (7) ausgebildet ist.

8. Strahlungsemittierender Halbleiterchip nach einem der Ansprüche 1 bis 6,
bei dem die Schutzdiode (4) mittels der ersten Anschlussschicht (31) gebildet ist.

9. Strahlungsemittierender Halbleiterchip nach einem der Ansprüche 1 bis 8,
bei dem ein Aufwachssubstrat (200) für die Halbleiterschichtenfolge des Halbleiterkörpers (2) zumindest bereichsweise entfernt ist.

10. Strahlungsemittierender Halbleiterchip nach einem der Ansprüche 1 bis 9,
der als LED-Chip, RCLED-Chip oder als Laserdiodenchip ausgeführt ist.

11. Verfahren zur Herstellung eines strahlungsemittierenden Halbleiterchips mit den Schritten:
a) Bereitstellen eines Halbleiterkörpers (2) mit einer Halbleiterschichtenfolge, die einen zur Erzeugung von Strahlung vorgesehenen aktiven Bereich (20), eine erste Halbleiterschicht (21) und eine zweite Halbleiterschicht (22) aufweist;
b) Ausbilden einer Ausnehmung (25) im Halbleiterkörper (2), die sich durch den aktiven Bereich (20) hindurch in die erste Halbleiterschicht (21) hinein erstreckt;
c) Ausbilden einer ersten Anschlussschicht (31) auf dem Halbleiterkörper (2), wobei sich die erste Anschlussschicht (31) in die Ausnehmung (25) hinein erstreckt und wobei die erste Anschlussschicht (31) mit der zweiten Halbleiterschicht (22) über eine Schutzdiode (4) elektrisch verbunden ist; und
d) Fertigstellen des Halbleiterchips, wobei zumindest bereichsweise zwischen der ersten Anschlussschicht (31) und der zweiten Halbleiterschicht (22) eine zweite Anschlussschicht (32) angeordnet ist, die mit der zweiten Halbleiterschicht (22) elektrisch leitend verbunden ist, wobei der Halbleiterchip einen Träger (5) aufweist, und wobei die erste Halbleiterschicht (21) auf der dem Träger (5) abgewandten Seite des aktiven Bereichs (20) angeordnet ist.

12. Verfahren nach Anspruch 11,
bei dem vor Schritt c) auf der zweiten Halbleiterschicht (22) eine Übergangsschicht (40) ausgebildet wird, die an die zweite Halbleiterschicht (22) angrenzt.

13. Verfahren nach Anspruch 12,
bei dem eine elektrische Kontaktfähigkeit der zweiten Halbleiterschicht (22) gezielt lokal verringert wird.

14. Verfahren nach Anspruch 13,
bei dem die elektrische Kontaktfähigkeit mittels Veraschens und/oder Sputterns verringert wird.

15. Verfahren nach einem der Ansprüche 11 bis 14,
bei dem die zweite Anschlussschicht (32) mittels bereichsweisen Entfernens des Halbleiterkörpers (2) freigelegt wird.

## Claims

1. A radiation emitting semiconductor chip (1) comprising a carrier (5) and a semiconductor body (2) with a semiconductor layer sequence, wherein
- the semiconductor layer sequence comprises an active region (20) provided for generating radiation, a first semiconductor layer (21), and a second semiconductor layer (22);
- said active region (20) is arranged between said first region (21) and said second region (22); and
- the first semiconductor layer (21) is arranged on the side of the active region (20) facing away from the carrier (5);
- the semiconductor body (2) comprises at least one recess (25) which extends through the active region (20);
- the first semiconductor layer (21) is electrically conductively connected with a first connection layer (31), wherein the first connection layer (31) in the recess (25) extends from the first semiconductor layer (21) towards the carrier (5); and
- the first connection layer (31) is electrically connected with the second semiconductor layer (22) via a protective diode (4); and
- a second connection layer (32), which is electrically conductively connected with the second semiconductor layer (22), is arranged at least in regions between the first connection layer (31) and the second semiconductor layer (22) .

2. The radiation-emitting semiconductor chip according to claim 1,
in which the first connection layer (31) extends at least in regions between the carrier (5) and the second semiconductor layer (22).

3. radiation-emitting semiconductor chip according to claim 1 or 2,
in which the protective diode (4) is designed as a Schottky diode.

4. The radiation-emitting semiconductor chip according to any one of claims 1 to 3,
in which the protective diode (4) overlaps with the semiconductor body (2) in top view onto the semiconductor chip (1).

5. The radiation emitting semiconductor chip according to any one of claims 1 to 4,
in which the protective diode (4) is formed by means of the second semiconductor layer.

6. The radiation-emitting semiconductor chip according to any one of claims 1 to 5,
in which a radiation exit surface (10) of the semiconductor body facing away from the carrier is free from an external electrical contact.

7. The radiation-emitting semiconductor chip according to any one of the preceding claims,
in which the protective diode (4) is formed by means of a transition layer (40) adjacent to the second semiconductor layer (22), wherein an insulating layer (7) is formed between the transition layer (40) and the second connection layer (32) .

8. The radiation emitting semiconductor chip according to any one of claims 1 to 6,
in which the protective diode (4) is formed by means of the first connection layer (31).

9. The radiation-emitting semiconductor chip according to any one of claims 1 to 8,
wherein a growth substrate (200) for the semiconductor layer sequence of the semiconductor body (2) is removed at least in regions.

10. The radiation emitting semiconductor chip according to any one of claims 1 to 9,
which is implemented as an LED chip, RCLED chip or laser diode chip.

11. A method for producing a radiation emitting semiconductor chip comprising the steps:
(a) providing a semiconductor body (2) with a semiconductor layer sequence comprising an active region (20) provided for generating radiation, a first semiconductor layer (21) and a second semiconductor layer (22);
b) forming a recess (25) in the semiconductor body (2) extending through the active region (20) into the first semiconductor layer (21);
c) forming a first connection layer (31) on the semiconductor body (2), wherein the first connection layer (31) extends into the recess (25), and wherein the first connection layer (31) is electrically connected with the second semiconductor layer (22) via a protective diode (4); and
d) finishing the semiconductor chip, wherein a second connection layer (32) is arranged at least in regions between the first connection layer (31) and the second semiconductor layer (22), which second connection layer is electrically conductively connected with the second semiconductor layer (22), wherein the semiconductor chip comprises a carrier (5), and wherein the first semiconductor layer (21) is arranged on the side of the active region (20) facing away from the carrier (5).

12. The method according to claim 11,
wherein, prior to step c), a transition layer (40) is adapted on the second semiconductor layer (22), the transition layer (40) being adjacent to the second semiconductor layer (22).

13. The method according to claim 12,
wherein an electrical contact capability of the second semiconductor layer (22) is locally reduced in a targeted manner.

14. The method according to claim 13,
wherein the electrical contact capability is reduced by means of ashing and/or sputtering.

15. The method according to any one of claims 11 to 14,
in which the second connection layer (32) is exposed by removing the semiconductor body (2) in regions.

## Revendications

1. Puce en semi-conducteur émettrice de rayonnement (1) comprenant un support (5) et un corps semi-conducteur (2) ayant une séquence de couches en semi-conducteur, dans laquelle
- la séquence de couches en semi-conducteur comprend une région active (20) prévue pour générer un rayonnement, une première couche en semi-conducteur (21) et une deuxième couche en semi-conducteur (22)
- ladite région active (20) est disposée entre ladite première couche en semi-conducteur (21) et ladite seconde couche en semi-conducteur (22) ; et
- la première couche en semi-conducteur (21) est disposée sur le côté de la région active (20) opposé au support (5) ;
- le corps semi-conducteur (2) présente au moins un évidement (25) qui s'étend à travers la région active (20)
- la première couche en semi-conducteur (21) est connectée de manière électriquement conductrice à une première couche de connexion (31), la première couche de connexion (31) s'étendant dans l'évidement (25) à partir de la première couche en semi-conducteur (21) dans la direction du support (5) ; et
- la première couche de connexion (31) est connectée électriquement à la deuxième couche en semi-conducteur (22) par l'intermédiaire d'une diode de protection (4) ; et
- une deuxième couche de connexion (32), qui est reliée de manière électriquement conductrice à la deuxième couche en semi-conducteur (22), est disposée au moins dans certaines zones entre la première couche de connexion (31) et la deuxième couche en semi-conducteur (22).

2. Puce en semi-conducteur émettant des rayonnements selon la revendication 1,
dans lequel la première couche de connexion (31) s'étend au moins dans certaines zones entre le support (5) et la deuxième couche en semi-conducteur (22).

3. Puce en semi-conducteur émettant un rayonnement selon la revendication 1 ou 2,
dans laquelle la diode de protection (4) est réalisée sous la forme d'une diode Schottky.

4. Puce en semi-conducteur émettant des rayonnements selon l'une quelconque des revendications 1 à 3,
dans lequel la diode de protection (4) chevauche le corps semi-conducteur (2) lorsqu'elle est vue du dessus de la puce en semi-conducteur (1).

5. Puce en semi-conducteur émettant des rayonnements selon l'une quelconque des revendications 1 à 4,
dans lequel la diode de protection (4) est formée au moyen de la deuxième couche en semi-conducteur.

6. Puce en semi-conducteur émettant des rayonnements selon l'une quelconque des revendications 1 à 5,
dans lequel une surface de sortie de rayonnement (10) du corps semi-conducteur orientée à l'opposé du support est exempte d'un contact électrique externe.

7. Puce en semi-conducteur émettant des rayonnements selon l'une quelconque des revendications précédentes,
dans laquelle la diode de protection (4) est formée au moyen d'une couche de transition (40) qui est adjacente à la deuxième couche en semi-conducteur (22), une couche isolante (7) étant formée entre la couche de transition (40) et la deuxième couche de connexion (32).

8. Puce en semi-conducteur émettant des rayonnements selon l'une quelconque des revendications 1 à 6,
dans lequel la diode de protection (4) est formée au moyen de la première couche de connexion (31).

9. Puce en semi-conducteur émettant des rayonnements selon l'une quelconque des revendications 1 à 8,
dans lequel un substrat de croissance (200) pour la séquence de couches en semi-conducteur du corps semi-conducteur (2) est enlevé au moins dans certaines zones.

10. Puce en semi-conducteur émettant des rayonnements selon l'une quelconque des revendications 1 à 9,
qui est réalisée sous la forme d'une puce de LED, d'une puce de RCLED ou d'une puce de diode laser.

11. Procédé de fabrication d'une puce en semi-conducteur émettant des radiations, comprenant les étapes suivantes :
(a) fournir un corps semi-conducteur (2) ayant une séquence de couches en semi-conducteur comprenant une région active (20) prévue pour générer un rayonnement, une première couche en semi-conducteur (21) et une seconde couche en semi-conducteur (22) ;
b) former un évidement (25) dans le corps semi-conducteur (2) s'étendant à travers la région active (20) dans la première couche en semi-conducteur (21) ;
c) former une première couche de connexion (31) sur ledit corps semi-conducteur (2), ladite première couche de connexion (31) s'étendant dans ledit évidement (25), ladite première couche de connexion (31) étant connectée électriquement à ladite seconde couche en semi-conducteur (22) via une diode de protection (4) ; et
d) terminer la puce en semi-conducteur, dans laquelle une deuxième couche de connexion (32), qui est reliée de manière électriquement conductrice à la deuxième couche en semi-conducteur (22), est disposée au moins par zones entre la première couche de connexion (31) et la deuxième couche en semi-conducteur (22), dans laquelle la puce en semi-conducteur présente un support (5), et dans laquelle la première couche en semi-conducteur (21) est disposée sur le côté de la région active (20) qui est opposé au support (5).

12. Procédé selon la revendication 11,
dans lequel, avant l'étape c), une couche de transition (40) est formée sur la deuxième couche en semi-conducteur (22) et est adjacente à la deuxième couche en semi-conducteur (22).

13. Procédé selon la revendication 12,
dans lequel une capacité de contact électrique de la seconde couche en semi-conducteur (22) est réduite localement de manière ciblée.

14. Procédé selon la revendication 13,
dans lequel l'aptitude au contact électrique est réduite par incinération et/ou par pulvérisation.

15. Procédé selon l'une quelconque des revendications 11 à 14,
dans lequel la deuxième couche de connexion (32) est exposée en retirant le corps semi-conducteur (2) dans certaines zones.
